(19) Europäisches Patentamt

European Patent Office

Office européen des brevets

(11) Veröffentlichungsnummer: **0 288 421**
**B1**

(12) **EUROPÄISCHE PATENTSCHRIFT**

(51) Int. Cl.⁵: **H03K 17/12**, H03K 17/73

(45) Veröffentlichungstag der Patentschrift:
**28.11.90**

(21) Anmeldenummer: **88730087.9**

(22) Anmeldetag: **18.04.88**

(54) **Symmetrierung der abzuschaltenden Ströme parallelgeschalteter, gategesteuerter Halbleiter.**

(30) Priorität: **24.04.87 DE 3714174**

(43) Veröffentlichungstag der Anmeldung:
**26.10.88 Patentblatt 88/43**

(45) Bekanntmachung des Hinweises auf die Patenterteilung:
**28.11.90 Patentblatt 90/48**

(84) Benannte Vertragsstaaten:
**AT DE ES FR IT**

(56) Entgegenhaltungen:
**EP-A- 0 202 962
DE-A- 3 316 402
DE-A- 3 322 641
DE-A- 3 442 484
US-A- 4 199 694**

(73) Patentinhaber: **Licentia Patent-Verwaltungs-GmbH,
Theodor-Stern-Kai 1, D-6000 Frankfurt/Main 70(DE)**

(72) Erfinder: **Beinhold, Georg, Kaulbachstrasse 20a,
D-1000 Berlin 46(DE)**
Erfinder: **Niehage, Helmut, Thomas-Dehler-Strasse 3,
D-1000 Berlin 30(DE)**

(74) Vertreter: **Lertes, Kurt, Dr. et al, Licentia
Patent-Verwaltungs-GmbH Theodor-Stern-Kai 1,
D-6000 Frankfurt/M 70(DE)**

**Beschreibung**

Die Erfindung bezieht sich auf ein Verfahren gemäß dem Oberbegriff des Anspruchs 1 sowie auf eine Schaltungsanordnung zur Durchführung dieses Verfahrens. Eine derartige Schaltungsanordnung ist durch die DE-A 3 322 641 bekannt.

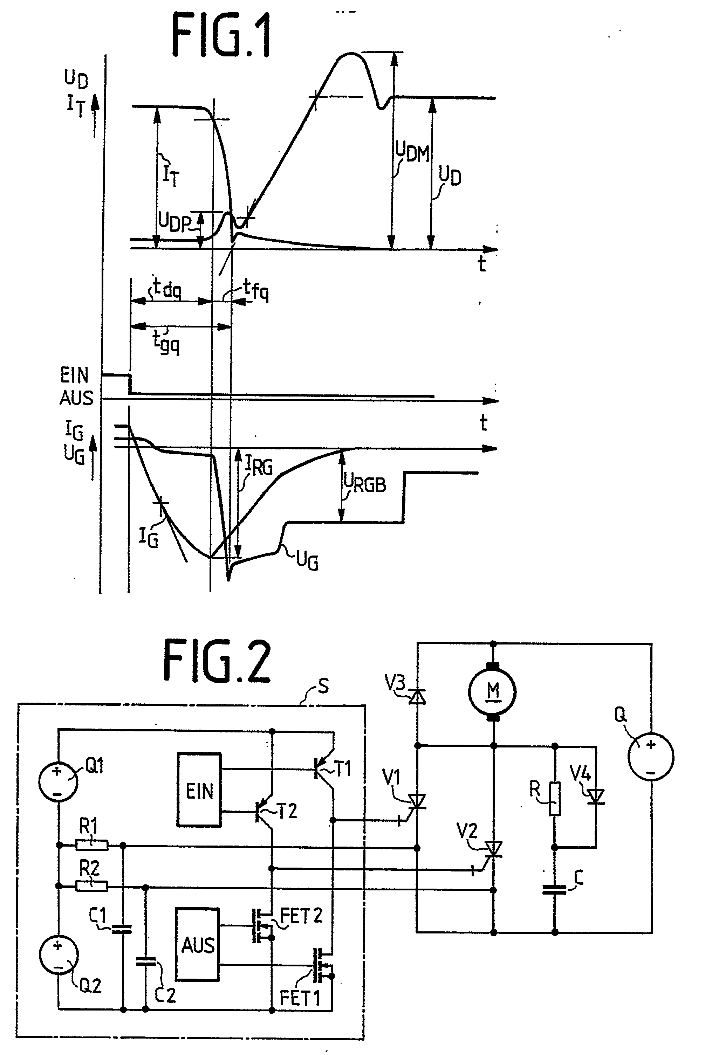

Unter gategesteuerten Halbleitern sollen hier sämtliche Halbleiterschalter verstanden sein, die über ihren Steueranschluß sowohl ein- als auch ausgeschaltet werden können, wie z.B. feldsteuerbare Transistoren (Insulated Gate Transistor) oder GTO-Thyristoren. Die Spannungs- und Stromverhältnisse im Anoden-Kathodenkreis sowie im Gate-Kathodenkreis beim Ausschalten eines GTO-Thyristors sind in Fig. 1 zusammen mit dem zeitlichen Verlauf des Schaltbefehls dargestellt. Mit dem Umschalten des Schaltbefehls von "EIN" auf "AUS" wird durch die Steuerschaltung ein negativer Gate-Strom $I_G$ über die Gate-Kathodenstrecke des GTO-Thyristors getrieben. Der Gate-Strom $I_G$ steigt bis zu einer Gate-Rückwärtssteuerstromspitze $I_{RG}$ an, um dann wieder auf Null abzufallen. Bei Erreichen dieser Gate-Rückwärtssteuerstromspitze $I_{RG}$ springt die Gate-Spannung $U_G$ steil an, um dann schließlich auf die Gate-Rückwärtssteuerspannung $U_{RGB}$ abzufallen. Während des Abschaltvorgangs fließt zunächst im Anoden-Kathodenkreis des GTO-Thyristors der Anodenstrom $I_T$ weiter, bis er schließlich im zeitlichen Bereich der Gate-Rückwärtssteuerstromspitze $I_{RG}$ steil auf einen sogenannten Schweifstrom abfällt. Die Zeit von der Abgabe des "AUS"-Schaltbefehls bis zum steilen Abfall des Anodenstroms wird als Abschaltverzugszeit $t_{dq}$ bezeichnet. Die Zeit des Abfalls des Anodenstroms $I_T$ bis zum Schweifstrom bezeichnet man als Abschaltfallzeit $t_{fq}$. Die Summe aus der Abschaltverzugszeit $t_{dq}$ und der Abschaltfallzeit $t_{fq}$ ist die Abschaltzeit $t_{gq}$ des GTO-Thyristors. Die Gleichspannung $U_D$ am GTO-Thyristor steigt während der Abfallzeit des Anodenstroms $I_T$ zunächst auf den Wert der sogenannten Nadelspannung $U_{DP}$, um dann im weiteren Verlauf des Abschaltvorgangs bis zu der Spitzenspannung $U_{DM}$ anzusteigen. Im abgeschalteten Zustand liegt am GTO-Thyristor schließlich dann die Gleichspannung $U_D$.

Ist es nötig, zur Erhöhung eines Laststromes mehrere GTO-Thyristoren parallelzuschalten, ist neben der gleichmäßigen Stromaufteilung während der Stromflußzeit auch auf die gleichmäßige Aufteilung der Ströme beim Abschalten der parallelgeschalteten GTO-Thyristoren zu achten. Dies ist von besonderer Bedeutung, da die Abschaltverzugszeiten von GTO-Thyristoren eine starke Exemplarstreuung aufweisen, und sich auch in Abhängigkeit vom Anodenstrom, der Temperatur sowie weiterer Parameter ändern können.

In Fig. 2 ist das Prinzipschaltbild für eine Parallelschaltung zweier gategesteuerter Halbleiter in Form von GTO-Thyristoren V1, V2 gezeigt. Diese bilden einen Gleichstromsteller für einen aus einer Gleichspannungsquelle Q gespeisten Motor M, dem eine Freilaufdiode V3 parallelgeschaltet ist. In üblicher Weise ist den Halbleitern V1, V2 die Parallelschaltung eines ohmschen Widerstands R und einer Beschaltungsdiode V4 im Reihe mit einem Beschaltungskondensator C parallelgeschaltet.

Die Ansteuerung der beiden gategesteuerten Halbleiter V1, V2 erfolgt über eine Steuerschaltung S, deren Steuerenergie zum Einschalten beider Halbleiter durch eine Spannungsquelle Q1 und zum Ausschalten beider Halbleiter durch eine Spannungsquelle Q2 aufgebracht wird. Zum Einschalten der beiden Halbleiter V1, V2 steuert ein Einschaltglied EIN zwei Einschalttransistoren T1, T2 in den leitenden Zustand. Zum Ausschalten der Halbleiter V1, V2 mittels eines negativen Steuerstromes sind zwei Feldeffekttransistoren FET1, FET2 von einem Ausschaltglied AUS in den leitenden Zustand steuerbar. Mit R1, R2 sind zwei ohmsche Widerstände und mit C1, C2 sind zwei Kondensatoren innerhalb der Steuerschaltung S bezeichnet.

Sollen die beiden Halbleiter V1, V2 abgeschaltet werden, so wird derjenige der beiden mit der größeren Abschaltverzugszeit den vollen, durch den Motor M fließenden Laststrom abschalten müssen, da der andere Halbleiter bereits abgeschaltet ist.

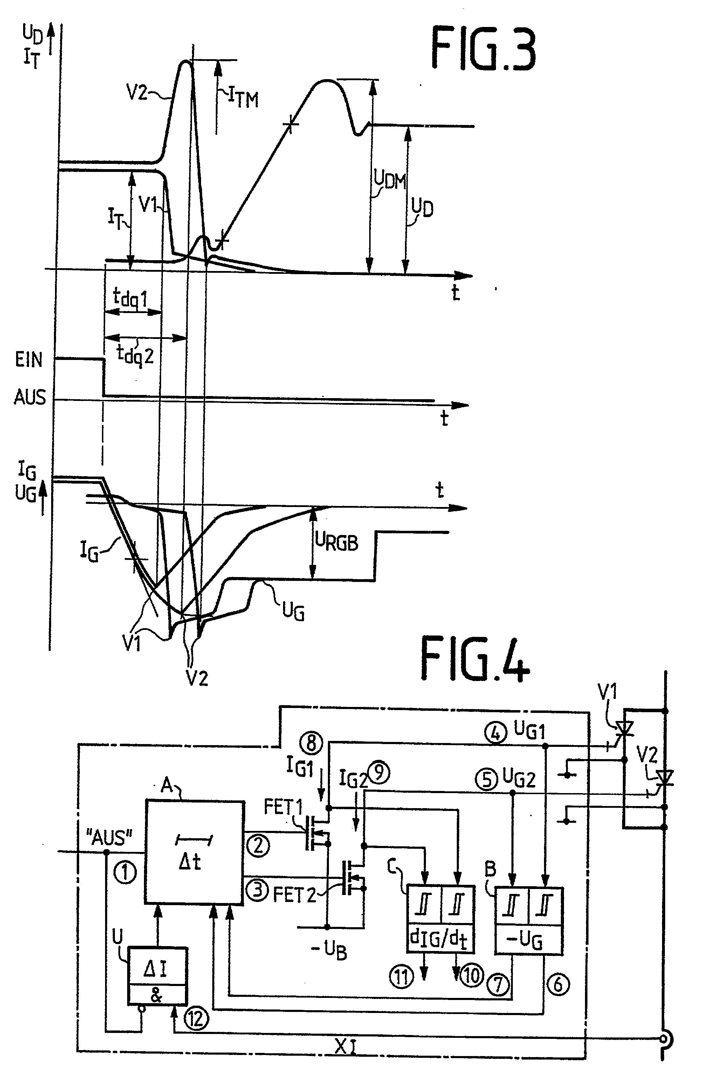

In Fig. 3 sind die Strom- und Spannungsverläufe für die beiden Halbleiter V1, V2 dargestellt, wenn sie zur gleichen Zeit den Ausschaltbefehl erhalten, aber unterschiedliche Abschaltverzugszeiten aufweisen.

Man erkennt, daß der negative Gate-Strom $I_G$ des Halbleiters V1 zu einem früheren Zeitpunkt die Gate-Rückwärtssteuerstromspitze aufweist als der Gate-Strom $I_G$ des Halbleiters V2. Der Anodenstrom $I_T$ des Halbleiters V1 fällt nach der kürzeren Abschaltverzugszeit $t_{dq1}$ auf seinen Schweifstrom ab, so daß der Anodenstrom $I_T$ des Halbleiters V2 in gleichem Maße ansteigen muß, wie der Strom $I_T$ im Halbleiter V1 abfällt. Bei normaler Dimensionierung der beiden Halbleiter V1, V2 führt das Ansteigen des Anodenstroms $I_T$ des Halbleiters V2 auf den Maximalwert $I_{TM}$ zu einer Überlastung des Halbleiters V2, bevor auch sein Strom nach der Abschaltverzugszeit $t_{dq2}$ auf den Schweifstrom abklingt.

Um derartige Überlastungen zu vermeiden, ist es notwendig, die abzuschaltenden Ströme parallelgeschalteter, gategesteuerter Halbleiter zu symmetrieren.

Bei der Schaltungsanordnung nach der eingangs genannten DE-A 33 22 641 wird die Symmetrierung der abzuschaltenden Ströme zweier parallelgeschalteter GTO-Thyristoren dadurch angestrebt, daß entweder die Gate-Anschlüsse, die Kathoden-Anschlüsse oder beide miteinander durch einen Leiter verbunden sind. Diese Methode ist in gewissen Grenzen bei der Herstellung von diskreten GTO's auf sehr engem Raum in einem Gehäuse möglich. Bei Verwendung fertiger Halbleiter ist in der Praxis trotz der Verbindung eine optimale Symmetrierung der parallelgeschalteten Halbleiter nicht möglich. Es wird deshalb hier trotz allem notwendig, durch Selektion diejenigen Halbleiter aus einem größeren Angebot herauszufinden, die in etwa gleiche Abschaltzeiten aufweisen. Dieses Verfahren ist beim nachträglichen Tausch von Halbleitern jedoch nicht möglich.

Ferner können die Einflüsse unterschiedlicher Ströme, Temperaturen sowie die Alterung nicht berücksichtigt werden.

Für seriell geschaltete, unterschiedlich lange Abschalt- bzw. Abschaltverzugszeiten aufweisende Thyristoren, deren Steueranschlüsse zum Abschalten von einer mit Schaltelementen versehenen Steuerschaltung mit Abschaltsignalen belegt werden, ist durch die DE-A 3 316 402 ein Verfahren zur Symmetrierung der an der Serienschaltung anliegenden Spannung bekannt. Die Symmetrierung wird dabei dadurch erreicht, daß die tatsächlichen Abschalt- bzw. Abschaltverzugszeiten der Thyristoren ermittelt werden und daß dann die Abschaltung der einzelnen Thyristoren um die bei dem vorhergehenden Abschaltvorgang ermittelte Zeitdifferenz ihrer Abschalt- bzw. Abschaltverzugszeit zu der längstdauernden Abschalt- bzw. Abschaltverzugszeit eines der in Reihe geschalteten Thyristoren durch die Abgabe eines Wiederzündungsimpulses effektiv verzögert wird.

Aus der EP-A 0 202 962 ist ein entsprechendes Verfahren für eine Reihenschaltung von Transistoren herleitbar. Dabei wird die Zeitdifferenz von der Abgabe des Abschaltsignals an bestimmt und eine Symmetrierung der an der Reihenschaltung anliegenden Spannung dadurch erreicht, daß das die Einschaltung der jeweiligen Transistoren bewirkende Signal durch ein Wiederzündungssignal verlängert wird.

Der Erfindung liegt die Aufgabe zugrunde, das eingangs angegebene Verfahren derart zu gestalten, daß bei beliebig vielen parallelgeschalteten, gategesteuerten Halbleitern eine optimale Symmetrierung der abzuschaltenden Ströme auch bei stark unterschiedlichen Abschaltzeiten der einzelnen Halbleiter erreicht wird.

Diese Aufgabe wird gemäß der Erfindung durch die im Anspruch 1 gekennzeichneten Merkmale gelöst.

Die verschiedenen Abschaltzeiten, bzw. Abschaltverzugszeiten werden also durch Veränderung der Abschaltbefehlszeiten kompensiert, was dazu führt, daß der Anodenstrom aller parallelgeschalteten Halbleiter zum gleichen Zeitpunkt auf den Schweifstrom absinkt. Der Gesamtstrom wird also gleichzeitig von allen Halbleitern abgeschaltet, so daß eine Überlastung des Halbleiters mit der größeren Abschalt- bzw. Abschaltverzugszeiten durch den vollen Laststrom vermieden wird.

Vorteilhafte Ausgestaltungen des Verfahrens nach der Erfindung sowie Schaltungsanordnungen zur Durchführung des Verfahrens sind in den restlichen Ansprüchen gekennzeichnet.

Das Verfahren nach der Erfindung soll beispielhaft anhand der Zeichnung im folgenden erläutert werden. Es zeigen

Fig. 4 das Prinzipschaltbild einer Steuerschaltung zur Durchführung des Verfahrens nach der Erfindung,

Fig. 5 ein Ablaufdiagramm einer Regelung der in Fig. 4 gezeigten Halbleiter auf gleiche Abschaltzeitpunkte,

Fig. 6 ein Ablaufdiagramm der Regelung der in Fig. 4 gezeigten Halbleiter auf gleiche Abschaltverzugszeitpunkte und

Fig. 7 den Verlauf der Abschaltverzugszeit als Funktion des momentanen Abschaltstromes durch die in Fig. 4 gezeigten Halbleiter.

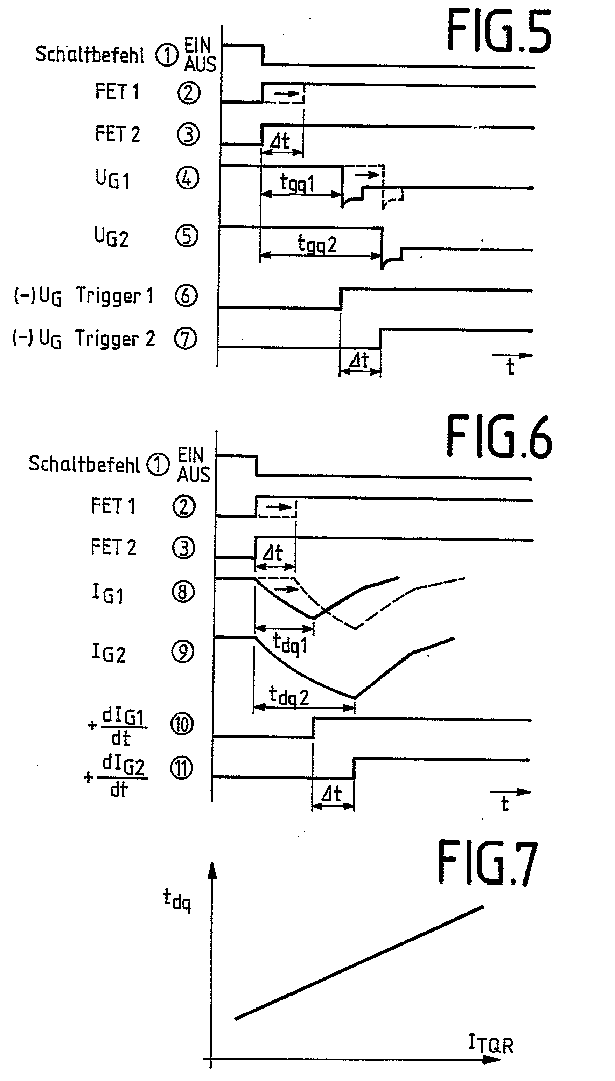

Durch die in Fig. 4 dargestellte Schaltungsanordnung werden die beiden parallelgeschalteten, als GTO-Thyristoren ausgebildeten Halbleiter V1, V2 zum gleichen Zeitpunkt abgeschaltet. Der zum Einschalten der beiden Halbleiter V1, V2 notwendige Teil der Steuerschaltung ist, da er zur Erläuterung der Erfindung nicht erforderlich ist, nicht gezeigt.

Zum Abschalten der beiden Halbleiter V1, V2 steuert ein in seiner Funktionsweise später noch zu erläuternder Differenzzeitregler A bei einem ihm zugeführten Signal "AUS" zwei als Feldeffekttransistoren ausgebildete Schaltelemente FET1, FET2 in den leitenden Zustand, so daß eine Spannungsquelle - $U_B$ negative Gate-Kathodenströme $I_{G1}$, $I_{G2}$ durch die beiden Halbleiter V1, V2 treibt.

Wird davon ausgegangen, daß beide Halbleiter V1, V2 gleiche Abschaltfallzeiten $t_{fq}$ aufweisen, so kann die Abschaltzeit $t_{gq}$ als Maß auch für die Abschaltverzugszeit $t_{dq}$ gelten. Ein Indiz für das Ende der Abschaltzeit $t_{gq}$ ist - wie aus Fig. 1 zu entnehmen - das Anspringen der negativen Gate-Kathoden-Spannung - $U_G$.

Gemäß Fig. 4 wird das plötzliche Ansteigen der negativen Gate-Kathoden-Spannungen - $U_{G1}$ bzw. - $U_{G2}$ bei den Halbleitern V1 bzw. V2 durch je einen Komparator B ermittelt. Die Ausgangssignale der Komparatoren B werden dem Differenzzeitregler A zugeführt, der die beiden Abschaltzeitpunkte miteinander vergleicht und die Differenzzeit $\Delta t$ feststellt. Ist z. B. die Abschaltzeit $t_{gq1}$ des Halbleiters V2 um die Differenzzeit $\Delta t$ kürzer als die Abschaltzeit $t_{gq2}$ des Halbleiters V2, steuert der Differenzzeitregler A den Feldeffekttransistor FET1 um die Zeit $\Delta t$ später an, so daß auch das Anspringen der negativen Gate-Kathoden-Spannung $U_{G1}$ um die Zeit $\Delta t$ später plötzlich ansteigt und damit die Abschaltzeitpunkte der beidem Halbleiter V1, V2 zusammenfallen.

Dieser zuvor beschriebene Abschaltvorgang wird in seiner zeitlichen Zuordnung in Fig. 5 verdeutlicht. Zum besseren Verständnis sind in Fig. 4 Ziffern 1 bis 7 als Hinweis auf die in Fig. 5 dargestellten zeitlichen Verläufe der Signale an diesen Stellen eingetragen. Bei einem Schaltbefehl "AUS" werden zunächst die beiden Felfeffekttransitoren FET1, FET2 gleichzeitig angesteuert. Die negative Gate-Kathoden-Spannung $U_{G1}$ des Halbleiters V1 springt dabei um die Zeit $\Delta t$ früher an als die negative Gate-Kathoden-Spannung $U_{G2}$ des Halbleiters V2. Die Triggersignale, die die Komparatoren B an den Differenzzeitregler A liefern, sind mithin um die Zeit $\Delta t$ zeitlich verschoben. Der Differenzzeitregler A verschiebt daraufhin die Ansteuerung des Feldeffekttransistors FET1 um die Zeit $\Delta$ t, wie dieses gestrichelt dargestellt ist. Entsprechend später springt dadurch, wie ebenfalls gestrichelt dargestellt ist, die negative Gatespannung $U_{G1}$ des Halbleiters V1 auf den hohen negativen Wert, so daß die Zeit $\Delta$ t zwischen den beiden Abschaltzeiten $t_{gq1}$ des Halbleiters V1 und $t_{gq2}$ des Halbleiters V2 zu Null wird. Diese Korrektur wird laufend vorgenommen, so daß bei Veränderungen der äußeren Parameter, wie z. B. des Stromes oder der Temperatur ein entsprechendes Ausregeln erfolgen kann. Gestartet wird die beschriebene Regelung durch den Differenzzeitregler A bei geringer Aussteuerung der beiden Halbleiter V1, V2, damit die großen Korrekturen, die durch die Exemplarstreuung hervorgerufen werden, bei kleinem Strom, also noch im zulässigen Bereich der Abschaltfähigkeit der Halbleiter V1 bzw. V2 vorgenommen werden können.

Falls die Abschaltfallzeiten $t_{fq}$ der einzelnen Halbleiter in der Parallelschaltung zu stark differieren oder aufgrund halbleiter- oder schaltungsspezifischer Notwendigkeiten die Abschaltverzugszeiten $t_{dq}$ miteinander verglichen werden müssen, so kann als Indiz für den Zeitpunkt des Endes der Abschaltverzugszeiten $t_{dq}$ der einzelnen Halbleiter der Zeitpunkt der negativen Stromspitze während des Abschaltvorgangs im Gate-Kathoden-Kreis der Halbleiter genommen werden. Zu diesem Zeitpunkt ändert sich das Vorzeichen der Steigung des Abschaltsignals, also des Stromes $I_G$ von negativen zu positiven Werten.

Statt der Komparatoren B werden in diesem Fall, wie ebenfalls in Fig. 4 dargestellt ist, Komparatoren C eingesetzt. Die Gateströme $I_G$ werden als Spannungsabfall an den Feldeffekttransistoren FET1, FET2 abgegriffen und nach der Zeit t differenziert den Komparatoren C zugeführt. Die Komparatoren C geben ein Signal an den Differenzzeitregler A, wenn jeweils die zeitliche Ableitung der Gateströme $dI_{G1}/dt$ und $dI_{G2}/dt$ positiv werden. Der Differenzzeitregler A verschiebt dann wiederum die Abgabe der Abschaltsignale - wie bereits bei der Regelung auf gleiche Abschaltzeiten $t_{gq}$ beschrieben - für die einzelnen Halbleiter V1, V2 um die Zeitdifferenz $\Delta$ t.

In Fig. 6 ist zum besseren Verständnis das Ablaufdiagramm dieser Regelung auf gleiche Abschaltverzugszeitpunkte angegeben. Dabei sind wiederum die Signalverläufe mit Ziffern versehen, die denjenigen Stellen in Fig. 4 entsprechen, an denen die Signale auftreten.

Gemäß Fig. 6 werden wiederum bei einem Schaltbefehl "AUS" die beiden Feldeffekttransistoren FET1, FET2 durch den Differenzzeitregler A in den leitenden Zustand gesteuert. Dabei fließt in dem Gate-Kathoden-Kreis des Halbleiters V1 ein Gatestrom $I_{G1}$, dessen Abschaltverzugszeit $t_{gq}$ kürzer ist als die Abschaltverzugszeit $t_{dq2}$ des Gatestroms $I_{G2}$. Entsprechend der Umkehr der Steigung der Gateströme $I_{G1}$, $I_{G2}$ zum Zeitpunkt der negativen Stromspitzen geben die Komparatoren C (Fig. 4) Signale $dI_{G1}/dt$ und $dI_{G2}/dt$ an den Differenzzeitregler A ab, die um die Zeitdifferenz $\Delta$ t verschoben sind.

Der Differenzzeitregler A verschiebt daraufhin die Ansteuerung des Feldeffekttransistors FET1 um die Zeit $\Delta$ t, wie es gestrichelt in Fig. 6 dargestellt ist. Dementsprechend verschiebt sich der Gatestrom $I_{G1}$, so daß seine Gate-Rückwärts-Steuerstromspitze mit der Steuerstromspitze des Gatestroms $I_{G2}$ zusammenfällt und die Zeitdifferenz $\Delta$ t zu Null wird. Die Halbleiter V1, V2 schalten also auch in diesem Fall zu gleicher Zeit ab.

Verändert sich der durch die beiden Halbleiter V1, V2 fließende Abschaltstrom, so verändert sich auch die Abschalt- bzw. Abschaltverzugszeit. Der Verlauf der Abschaltverzugszeit $t_{dq}$ als Funktion des momentanen Abschaltstromes $I_{TQR}$ ist in Fig. 7 dargestellt.

Ergänzend zur Regelung auf gleiche Abschaltzeitpunkte (Komparatoren B) oder alternativ auf gleiche Abschaltverzugszeitpunkte (Komparatoren C) ist dem Differenzzeitregler A ein Differenzbildner U vorgeschaltet, durch den der Laststromeinfluß auf die Abschalt- bzw. Abschaltverzugszeit kompensiert wird. Das ist ebenfalls in Fig. 4 dargestellt.

Zu diesem Zweck prüft der Differenzbildner U, ob der momentane Wert des gegenwärtig abzuschaltenden Stromes sich gegenüber dem Wert des diesem momentanen leitenden Zustand vorausgegangenen leitenden Zustands der Halbleiter verändert hat, und gibt ein entsprechendes Differenzsignal $\Delta$ I an den Differenzzeitregler A, um die vor der gegenwärtigen Leitphase ermittelte Verzugszeit $\Delta$ t entsprechend dem in Fig. 7 gezeigten linearen Zusammenhang zu korrigieren. Die Korrektur, die besonders dann wichtig ist, wenn sich die Ströme durch die Halbleiter V1, V2 plötzlich verändern können, kann multiplikativ durchgeführt werden.

Der Differenzbildner U ist zwecks Zufuhr des Stromistwerts $x_I$ an einen Shunt im Halbleiterstromkreis angeschlossen.

Die Abgabe des Differenzsignals $\Delta$ I an den Differenzzeitregler A ist nur während des leitenden Zustands der Halbleiter V1, V2 möglich, da der Differenzbildner U nur durch den invertierten, dem Differenzzeitregler A zugeführten Schaltbefehl "AUS" aktiviert wird.

**Patentansprüche**

1. Verfahren zur Symmetrierung der abzuschaltenden Ströme parallelgeschalteter, unterschiedlich lange Abschalt- bzw. Abschaltverzugszeiten aufweisender gategesteuerter Halbleiter, deren Steueranschlüsse bzw. Gates zum Abschalten von einer mit Schaltelementen versehenen Steuerschaltung mit Abschaltsignalen belegt werden, dadurch gekennzeichnet, daß zunächst schrittweise bei kleinen Strömen die tatsächlichen Abschalt- bzw. Abschaltverzugszeiten der Halbleiter gemessen vom Zeitpunkt der Abgabe des Abschaltsignals an ermittelt werden und daß dann bei schrittweise bis zum vollen Betriebsstrom gesteigerten Strömen jeweils die Abgabe der Abschaltsignale für den einzelnen Halbleiter um die bei dem vorhergehenden Abschaltvorgang ermittelte Zeitdifferenz seiner Abschalt- bzw. Abschaltverzugszeit zu der längstandauernden Abschalt- bzw. Abschaltverzugszeit eines der parallelgeschalteten Halbleiter verzögert wird.

2. Verfahren nach Anspruch 1, dadurch gekennzeichnet, daß das Ende der Abschaltzeit eines Halbleiters jeweils durch das plötzliche Ansteigen seiner negativen Gate-Kathodenspannung erfaßt wird.

3. Verfahren nach Anspruch 1, dadurch gekennzeichnet, daß das Ende der Abschaltverzugszeit eines Halbleiters jeweils durch die Vorzeichenänderung der Steigung des Abschaltsignals erfaßt wird.

4. Verfahren nach einem der Ansprüche 1 bis 3, dadurch gekennzeichnet, daß die jeweils ermittelten Abschalt- bzw. Abschaltverzugszeiten der Halbleiter entsprechend der Differenz der Momentanwerte der Ströme durch die Halbleiter während zweier aufeinanderfolgender leitender Zustände der Halbleiter korrigiert werden.

5. Schaltungsanordnung zur Durchführung der Verfahrens nach Anspruch 1, gekennzeichnet durch einen Differenzzeitregler (A)
- der eingangsseitig mit dem Ausgang der die Abschalt- bzw. Abschaltverzugszeit jedes Halbleiters (V1, V2) erfassenden Komparatoren (B bzw. C) verbunden ist,
- dem eingangsseitig ein Signal (AUS) zum Ausschalten der Halbleiter (V1, V2) zuführbar ist,
- der ausgangsseitig mit den Steueranschlüssen von das Abschaltsignal auf den Steueranschluß eines Halbleiters (V1, V2) schaltenden Schaltelementen (FET1, FET2) verbunden ist und
- dessen Ausgangssignale zeitverzögert in Abhängigkeit von dem über die Komparatoren (B bzw. C) vorgegebenen Ende der Abschalt- bzw. Abschaltverzugszeit für die einzelnen Halbleiter (V1, V2) an die diesen zugeordneten Schaltelemente (FET1, FET2) abgegeben werden.

6. Schaltungsanordnung nach Anspruch 5 zur Durchführung des Verfahrens nach Anspruch 3, dadurch gekennzeichnet, daß unter Verwendung von Feldeffekttransistoren als Schaltelemente (FET1, FET2) zum Schalten der Abschaltsignale auf die Steueranschlüsse der Halbleiter (V1, V2) der Spannungsabfall an diesen Feld effekttransistoren abgegriffen und nach der Zeit differenziert zur Bestimmung der Abschaltverzugszeit den Komparatoren (C) zugeführt ist.

7 Schaltungsanordnung nach einem der Ansprüche 5 oder 6 zur Durchführung des Verfahrens nach Anspruch 4, dadurch gekennzeichnet, daß der Differenzzeitregler (A) eingangsseitig zusätlich mit dem Ausgang eines Differenzbildners (U) zwischen den Momentanwerten des Stromes durch die Halbleiter (V1, V2) während zweier aufeinanderfolgender leitender Zustände der Halbleiter (V1, V2) verbunden ist, der eingangsseitig während des leitenden Zustands der Halbleiter (V1, V2) an einen Shunt im Halbleiterstromkreis angeschlossen ist.

**Claims**

1. A method for symmetrization of the currents to be turned off of gate-controlled semiconductors being connected in series and having different turn-off times or turn-off delay times, resp., the control terminals or gates being provided with turn-off signals for turning a control circuit having switching elements off, characterised in that first, with low currents, the actual turn-off times or turn-off delay times, resp., of the semiconductors beginning from the time of delivery of the turn-off signal are determined, and that then, for currents being gradually increased up to the maximum operating current, delivery of the turn-off signals for the individual semiconductors is delayed by the time difference determined during the previous turn-off operation of its turn-off time or turn-off delay time, resp., relative to the longest turn-off time or turn-off delay time, resp., of a semiconductor connected in parallel.

2. A method according to claim 1, characterised in that the end of the turn-off time of a semiconductor is detected by a sudden increase of its negative cathode voltage.

3. A method according to claim 1, characterised in that the end of the turn-off delay time of a semiconductor is detected by change of sign of the slope of the turn-off signals.

4. A method according to one of claims 1 to 3, characterised in that the determined turn-off times and turn-off delay times, resp., of the semiconductors are corrected corresponding to the difference of the instantaneous values of the currents through the semiconductors during two successive conductive states of said semiconductors.

5. A circuit for executing the method of claim 1, characterised by a differential time regulator (A)
– which is connected at its input with the output of the comparators (B or C) detecting the turn-off times or turn-off delay times, resp., of each semiconductor (V1, V2),
– to the input of which can be fed a signal (AUS) for turning the semiconductors (V1, V2) off,
– which is connected at its output with the control terminals of switching elements (FET1, FET2) supplying the turn-off signal io the control terminal of a semiconductor, and
– the output signals of which are delivered in time-delayed manner depending on the end of the turn-off time or turn-off delay time, resp., for the individual semiconductors (V1, V2) to the switching elements (FET1, FET2) assigned thereto, said end of times being given by the comparators (B or C, resp.).

6. A circuit according to claim 5 for executing the method of claim 3, characterised in that by using field-effect transistors for the switching elements (FET1, FET2) for supplying the turn-off signals to the control terminals of the semiconductors (V1, V2), the voltage drop is taken from said field-effect transistors, is differentiated with respect to the time and is fed to the comparators (C) for determination of the turn-off delay time.

7. A circuit according to one of claims 5 or 6 for executing the method of claim 4, characterised in that the differential time regulator (A) is connected ai its input in addition with the output of a differential former (U) between the instantaneous values of the current through the semiconductors (V1, V2) during two successive conductive states of said semiconductors (V1, V2), said differential former being connected at its input during the conductive state of the semiconductors (V1, V2) with a shunt in the semiconductor circuit.

## Revendications

1. Procédé de symétrisation des courant à couper par des semiconducteurs commandés par la grille, montés en parallèle et présentant des différences de temps de coupure ou de retard de coupure, dont les broches de commande ou les grilles reçoivent des signaux de coupure d'un circuit de commande possédant des éléments de commutation, caractérisé en ce que les valeurs effectives de temps de coupure et de retard de coupure des semiconducteurs à partir de l'application du signal de coupure sont d'abord déterminées à ses petites valeurs de courant, et en ce que, ensuite, à des courants progressivement augmentés jusqu'au courant de service total, l'application des signaux de coupure aux semiconducteurs individuels est retardée de la différence de temps déterminée lors de l'opération de coupure précédente entre le temps de coupure ou le retard de coupure du composant considéré et le temps de coupure ou retard de coupure le plus long de l'un des semiconducteurs montös en parallèle.

2. Procédé selon la revendication 1, caractérisé en ce que la fin du temps de coupure d'un semiconducteur est déterminée par la montée brutale de sa tension négative grille-cathode.

3. Procédé selon la revendication 1, caractérisé en ce que la fin du retard de coupure d'un semiconducteur est déterminée par le changement de signe de la pente du signal de coupure.

4. Procédé selon l'une des revendications 1 à 3, caractérisé en ce que les temps de coupure ou retard de coupure déterminés des semiconducteurs sont corrigés en fonction de la différence entre les valeurs instantanées des courants traversant les semiconducteurs pendant deux états passants successifs des semiconducteurs.

5. Circuit de mise en œuvre du procédé selon la revendication 1, caractörisé par un temporisateur différentiel (A) relié à l'entrée à la sortie des comparateurs (B ou C) déterminant le temps de coupure ou le retard de coupure de chaque semiconducteurs (V1, V2), pouvant recevoir en entrée un signal (AUS) de coupure des semiconducteurs (V1, V2), relié en sortie aux broches de commande des éléments de commutation (FET1, FET2) appliquant le signal de coupure aux broches de commande d'un semiconducteur (V1, V2) et dont les signaux de sortie sont appliqués aux éléments de commutation (FET1, FET2) avec un décalage dans le temps qui est fonction de la fin des temps de coupure ou des retards de coupure des semiconducteurs correspondants (V1, V2) déterminée à l'aide des comparateurs (B ou C).

6. Circuit selon la revendication 5, pour la mise en œuvre du procédé selon la revendication 3, caractérisé en ce que, avec des transistors à effet de champ (FET1, FET2) utilisés comme éléments de commutation pour appliquer les signaux de coupure aux broches de commande des semiconducteurs (V1, V2), la chute de tension aux bornes de ces transistors à effet de champ est analysée et envoyée aux comparateurs (C) avec différenciation dans le temps pour déterminer le retard de coupure.

7. Circuit selon l'une des revendications 5 ou 6 pour la mise en œuvre du procédé selon la revendication 4, caractérisé en ce que le temporisateur différentiel (A) est en outre relié en entrée é la sortie d'un soustracteur (U) établissant la différence entre les valeurs instantanées du courant traversant les semiconducteurs (V1, V2) au cours de deux états passants successifs des semiconducteurs (V1, V2) qui est lui-même relié en entrée à un shunt du circuit de courant du semiconducteur pendant l'état passant du semiconducteur (V1, V2).

# FIG.1

# FIG.2

EP 0 288 421 B1

FIG.3

FIG.4

# FIG.5

Schaltbefehl ① EIN / AUS

FET 1 ②

FET 2 ③ $\Delta t$

$U_{G1}$ ④ $t_{gq1}$

$U_{G2}$ ⑤ $t_{gq2}$

$(-)U_G$ Trigger 1 ⑥

$(-)U_G$ Trigger 2 ⑦ $\Delta t$ $t$

# FIG.6

Schaltbefehl ① EIN / AUS

FET 1 ②

FET 2 ③ $\Delta t$

$I_{G1}$ ⑧

$I_{G2}$ ⑨ $t_{dq1}$ $t_{dq2}$

$+\dfrac{dI_{G1}}{dt}$ ⑩

$+\dfrac{dI_{G2}}{dt}$ ⑪ $\Delta t$ $t$

# FIG.7

$t_{dq}$

$I_{TQR}$